# EUROPÄISCHE PATENTANMELDUNG

(11) **EP 3 367 431 A1**
(43) Veröffentlichungstag der Anmeldung: **29.08.2018**
(21) Anmeldenummer: 17000309.9
(22) Anmeldetag: 28.02.2017
(51) Int. Cl.: H01L 23/36, H01L 23/367, H01L 23/40

(54) **KÜHLVORRICHTUNG ZUR ENTWÄRMUNG EINES LEISTUNGSHALBLEITERMODULS**

(71) Anmelder: Siemens Aktiengesellschaft, 80333 München (DE)
(72) Erfinder: Werner, Pascal, 91325 Adelsdorf (DE)

(57) **Zusammenfassung**

Die Erfindung betrifft eine Kühlvorrichtung (1) zur Entwärmung eines Leistungshalbleitermoduls (2), umfassend das Leistungshalbleitermodul (2) und einen Kühlkörper (6), wobei das Leistungshalbleitermodul (2) eine Bodenplatte (3) und mindestens einen Leistungshalbleiter-Chip (5) aufweist, wobei die Bodenplatte (3) an ihrer ersten Seite (4) mechanisch mit dem mindestens einen Leistungshalbleiter-Chip (5) verbunden ist, wobei die Bodenplatte (3) mit dem Kühlkörper (6) mechanisch verbindbar ist und der Kühlkörper (6) im Betrieb eine Wärmesenke für die von dem mindestens einen Leistungshalbleiterchip (5) als Wärmequelle über die Bodenplatte (3) abgegebene Verlustwärme bildet, wobei an einer von der ersten Seite (4) der Bodenplatte (3) abgewandten und dem Kühlkörper (6) zugewandten zweiten Seite (7) der Bodenplatte (3) eine Ausbuchtung (8) vorgesehen ist, wobei an dem Kühlkörper (6) eine als Negativabbild der Ausbuchtung (8) der Bodenplatte (3) ausgebildete Einbuchtung (9) vorgesehen ist und wobei die Ausbuchtung (8) der Bodenplatte (3) in die Einbuchtung (9) des Kühlkörpers (6) zumindest teilweise versenkbar ist. Die Erfindung betrifft ferner einen Stromrichter (15) mit der Kühlvorrichtung (1).

## Beschreibung

### Kühlvorrichtung zur Entwärmung eines Leistungshalbleitermoduls

Die Erfindung betrifft eine Kühlvorrichtung zur Entwärmung eines Leistungshalbleitermoduls und einen Stromrichter mit der Kühlvorrichtung.

Für Stromrichter, welche beispielsweise als Frequenzumrichter mit einem am Gleichspannungszwischenkreis angeordneten Gleichrichter bzw. Wechselrichter in der Antriebstechnik zum Einsatz kommen, werden Leistungshalbleiter-Chips zum Schalten der elektrischen Energie oft sehr eng an den thermischen, elektrischen und geometrischen Anforderungen von Leistungshalbleitermodulen ausgerichtet, in welche sie integriert sind. Die Leistungshalbleitermodule können dabei jeweils nur einen einzelnen Leistungshalbleiter-Chip aufweisen oder mittels mehrerer Leistungshalbleiter-Chips beispielsweise eine Sechspuls-Brückenschaltung bilden.

Derartige Leistungshalbleitermodule sind aufgrund ihrer bekannten thermischen, elektrischen und geometrischen Bemessungsdaten für verschiedenste Anwendungsfälle in Produkten der Antriebstechnik und der Energieversorgung/Energieverteilung einsetzbar. Im Allgemeinen werden diese Leistungshalbleitermodule mit mehr oder weniger großen Abstufungen ihrer Bemessungsdaten für einen Massenmarkt entwickelt und hergestellt.

Sind nun einerseits die thermischen, elektrischen und geometrischen Bemessungsdaten des Leistungshalbleitermoduls für den Anwender akzeptabel, kann eine Auslegung und Montage beispielsweise bei der Herstellung von Stromrichtern vergleichsweise aufwandsarm gegenüber Lösungen insbesondere ohne derartige Leistungshalbleiter-Modultechnologien erfolgen. Andererseits nehmen derart vorgefertigte Leistungshalbleiter-module mit ihren thermischen und elektrischen Eigenschaften, ihrer geometrischen Topologie und den sich daraus ergebenden wenigen Einbaumöglichkeiten die Flexibilität und Kreativität für den Entwurf und die Realisierung innovativer bzw. technisch anspruchsvoll umzusetzender Lösungen.

Dies gilt demnach dann, wenn die Einbaugröße, der Einbauort bzw. die Einbauanordnung - also das geometrische Abmaß bzw. die Einbaumöglichkeiten des Leistungshalbleitermoduls beispielsweise im Stromrichter - mit den thermischen und elektrischen Eigenschaften nur schwer in Einklang zu bringen sind.

Die hier genannten thermischen Eigenschaften beziehen sich im Wesentlichen auf die während des Betriebs erzeugte Verlustwärme des Leistungshalbleiter-Chips, wobei für die Abführung von dessen Verlustwärme in der Regel eine Kühlvorrichtung vorgesehen ist, welche das geometrische Abmaß und die geometrische Anordnung des Leistungshalbleitermoduls mit dem Leistungshalbleiter-Chip oft signifikant bestimmt.

Auf der Suche nach einem entsprechend thermisch, elektrisch und geometrisch geeigneten Leistungshalbleitermodul muss der Anwender meist mit einer eher geringen Auswahl an verfügbaren Leistungshalbleitermodulen oder mit Einzellösungen rechnen, welche darüber hinaus oftmals nur von wenigen Herstellern/Lieferanten angeboten werden. Diese geringe Auswahlmöglichkeit kann dazu führen, dass der Hersteller/Lieferant die entsprechenden betriebswirtschaftlichen Aspekte der Bereitstellung (Kosten, Lieferzeiten etc.) gegenüber dem Anwender einseitig optimiert gestalten kann.

So kann sich beispielsweise ein Hersteller von Stromrichtern - welcher für den Massenmarkt produzierte Leistungshalbleitermodule einsetzen möchte - aufgrund von betriebswirtschaftlichen Erfordernissen genötigt fühlen, ein aus Sicht der geometrischen Abmessung und des Einbaus akzeptables aber am Rande der Unterdimensionierung ausgelegtes Leistungshalbleitermodul vorzusehen. Dies kann beim Betrieb des Stromrichters jedoch zu thermischen Problemen führen, welche in der Regel mit Einschränkungen der Verfügbarkeit in Grenzlastbereichen bzw. im Dauerbetrieb verbunden sind.

Die am Rande der Unterdimensionierung gewählten Leistungshalbleitermodule erfüllen demnach insbesondere die geforderten thermischen Parameter für einige spezifische Betriebsarten dann nur unzureichend. Ausgehend davon kann eine betriebsgefährdende Überlastung des Stromrichters die Folge sein oder es wird aus Erwägungen der Betriebssicherheit heraus eine bewusste Einschränkung der Effizienz des Stromrichters akzeptiert.

Der Erfindung liegt nunmehr die Aufgabe zugrunde, eine Kühlvorrichtung für ein Leistungshalbleitermodul mit mindestens einem Leistungshalbleiter-Chip bereitzustellen, welche die im Betrieb vorherrschenden thermischen Eigenschaften des Leistungshalbleitermoduls im Vergleich zu einem herkömmlichen Leistungshalbleitermodul verbessert.

Der Erfindung liegt die Erkenntnis zugrunde, dass ein bisheriges Leistungshalbleitermodul mit beispielsweise mehreren in einer Brückenschaltung verschalteten Leistungshalbleiter-Chips wenige Freiheitsgrade bzgl. des Einbaus bzw. der Anordnungen in einem elektrischen oder elektronischen Produkt - wie dem eines Stromrichters - aufweist. Im Allgemeinen sind hier alle diese Leistungshalbleiter-Chips des Leistungshalbleitermoduls an einem gemeinsamen Kühlkörper angeordnet, wobei allein das geometrische Abmaß des Kühlkörpers, als entweder zusätzlicher Anbaukörper oder als integraler Bestandteil des Leistungshalbleitermoduls, einen Großteil des gemeinsamen Platzbedarfs, beispielsweise in einem Stromrichter, ausmacht.

Aus diesen Überlegungen heraus ist für die Entwärmung des Leistungshalbleitermoduls ein effizienterer Wärmeübergang vom Leistungshalbleiter-Chip zum Kühlkörper in Form einer Reduzierung des thermischen Widerstands in der Regel immer erwünscht. Gleichzeitig mit der gewünschten Reduzierung des thermischen Widerstands für den effizienteren Wärmeübergang wird die oftmals verfolgte gemeinsame Anordnung der in einem Leistungshalbleitermodul als Brückenschaltung verschalteten Leistungshalbleiter-Chips hinterfragt.

Die Aufgabe wird durch eine Kühlvorrichtung mit den im Patentanspruch 1 angegebenen Merkmalen gelöst. Ferner wird die Aufgabe durch einen Stromrichter mit den im Patentanspruch 12 angegebenen Merkmalen gelöst.

Erfindungsgemäß wird eine Kühlvorrichtung zur Entwärmung eines Leistungshalbleitermoduls vorgeschlagen, umfassend das Leistungshalbleitermodul und einen Kühlkörper, wobei das Leistungshalbleitermodul eine Bodenplatte und mindestens einen Leistungshalbleiter-Chip aufweist, wobei die Bodenplatte an ihrer ersten Seite mechanisch mit dem mindestens einen Leistungshalbleiter-Chip verbunden ist, wobei der Kühlkörper mit der Bodenplatte mechanisch verbindbar ist und im Betrieb eine Wärmesenke für die von dem mindestens einen Leistungshalbleiter-Chip als Wärmequelle über die Bodenplatte abgegebene Verlustwärme bildet, wobei an einer von der ersten Seite der Bodenplatte abgewandten und dem Kühlkörper zugewandten zweiten Seite der Bodenplatte eine Ausbuchtung vorgesehen ist, wobei an dem Kühlkörper eine als Negativabbild der Ausbuchtung der Bodenplatte ausgebildete Einbuchtung vorgesehen ist und wobei die Ausbuchtung der Bodenplatte in die Einbuchtung des Kühlkörpers zumindest teilweise versenkbar ist.

Bei bisherigen Lösungen wird die Bodenplatte des Leistungshalbleitermoduls großflächig und möglichst plan mit dem Kühlkörper verbunden, was einen nur geringen thermischen Widerstand erzeugen soll. Allerdings treten an dieser mechanisch-thermischen Verbindung aufgrund von fertigungsbedingten Toleranzen der Oberflächen sowohl der Bodenplatte wie auch des Kühlkörpers Welligkeiten auf, was den thermischen Widerstand oftmals unerwünscht groß werden lässt.

Mittels der erfindungsgemäßen Kühlvorrichtung wird ein besonders vorteilhafter Wärmeübergang der von dem Leistungshalbleiter-Chip als Wärmequelle betrieblich erzeugten Verlustwärme über die Bodenplatte zum Kühlkörper erreicht, was in Folge dessen die thermischen Eigenschaften des Leistungshalbleitermoduls im Betrieb verbessert.

Durch die zumindest teilweise Versenkung der Ausbuchtung der Bodenplatte in die Einbuchtung des Kühlkörpers wird eine Vergrößerung der für den Wärmeübergang von der zweiten Seite der Bodenplatte zum Kühlkörper im Sinne der Erfindung signifikant thermisch/mechanisch verbundenen Flächen erreicht. Der thermische Widerstand zwischen der Bodenplatte und dem Kühlkörper wird so im Vergleich zu bisherigen - von ihren geometrischen Abmaßen und thermisch/mechanischen Verbindungen der Bodenplatte und des Kühlkörpers her - vergleichbaren Lösungen vorteilhaft reduziert.

Diese Reduzierung des thermischen Widerstands mittels der erfindungsgemäßen Kühlvorrichtung zwischen Bodenplatte und Kühlkörper - und der daraus folgenden verbesserten Entwärmung der Leistungshalbleiter-Chips - ist geeignet, auch eine Reduzierung des geometrischen Abmaßes des Leistungshalbleitermoduls (insbesondere von dessen Bodenplatte) in Verbindung mit dem Kühlkörper zu bilden.

Mittels der erfindungsgemäßen Kühlvorrichtung - und deren beschriebener Vorteile im Betrieb - wird beispielsweise für elektrische Brückenschaltungen in Stromrichtern eine räumliche Aufteilung von Leistungshalbleiter-Chips eines herkömmlichen Leistungshalbleitermoduls in vorteilhafter Weise unterstützt.

So ist eine Brückenschaltung auch aus mehreren einzelnen herkömmlichen Leistungshalbleitermodulen bildbar, welche beispielsweise jeweils nur einen Leistungshalbleiter-Chip aufweisen. Die Entwärmung derart einzeln ausgebildeter bisheriger Leistungshalbleitermodule ist mit dem Einsatz herkömmlicher Kühlvorrichtungen nur vergleichsweise technisch und betriebswirtschaftlich aufwändig herstellbar.

Mittels der erfindungsgemäßen Kühlvorrichtung wird nun eine freie räumliche Anordnung jedes einzelnen Leistungshalbleitermoduls - beispielsweise in Stromrichtern der Antriebstechnik - vorteilhaft unterstützt. Die Entwärmung ist dann meist auch unter Reduzierung des geometrischen Abmaßes der einzelnen Leistungshalbleitermodule (hauptsächlich deren Bodenplatte in Verbindung mit dem jeweiligen Kühlkörper) möglich.

Vorteilhafte Ausgestaltungsformen der Kühlvorrichtung sind in den abhängigen Ansprüchen angegeben.

Bei einer ersten vorteilhaften Ausgestaltungsform der erfindungsgemäßen Kühlvorrichtung ist an der von der ersten Seite der Bodenplatte abgewandten und dem Kühlkörper zugewandten zweiten Seite der Bodenplatte eine Einbuchtung vorgesehen, ist an dem Kühlkörper eine als Negativabbild der Einbuchtung der Bodenplatte ausgebildete Ausbuchtung vorgesehen und ist die Ausbuchtung des Kühlkörpers in die Einbuchtung der Bodenplatte zumindest teilweise versenkbar.

Diese Ausgestaltungsform weist unter Bezug auf die obigen Ausführungen zur erfindungsgemäßen Kühlvorrichtung, bei denen die Bodenplatte die Ausbuchtung und der Kühlkörper die Einbuchtung aufweist, vergleichbar vorteilhafte Eigenschaften auf.

Bei einer weiteren vorteilhaften Ausgestaltungsform der erfindungsgemäßen Kühlvorrichtung ist die Ausbuchtung in die Einbuchtung vollständig versenkbar.

Eine vollständige Versenkung der Ausbuchtung in die Einbuchtung verringert den thermischen Widerstand in vorteilhafter Weise weiter dadurch, dass die für den Wärmeübergang von der zweiten Seite der Bodenplatte zum Kühlkörper im Sinne der Erfindung signifikant mechanisch-thermisch verbundenen Flächen weiter vergrößert werden, obwohl sich das gemeinsame geometrische Abmaß von Leistungshalbleitermodul und Kühlkörper insgesamt nicht vergrößern, gegenüber der nur teilweisen Versenkung sich ggf. sogar verringert.

Bei einer weiteren vorteilhaften Ausgestaltungsform der erfindungsgemäßen Kühlvorrichtung weist die in die Einbuchtung versenkte Ausbuchtung eine Profilhöhe auf, welche mindestens 3mm in die Einbuchtung ragt.

Um einen ausreichenden technischen Effekt für die Verbesserung des thermischen Widerstands gegenüber Lösungen mit lediglich planen mechanischen-thermisch Verbindungen der Bodenplatte des Leistungshalbleitermoduls mit dem Kühlkörper zu erzielen, wird die Profilhöhe derart gewählt, dass mindestens 3mm der Ausbuchtung in die Einbuchtung hineinragen.

Bei einer weiteren vorteilhaften Ausgestaltungsform der erfindungsgemäßen Kühlvorrichtung ist die Bodenplatte mit der Ausbuchtung oder, sofern der Kühlkörper die Ausbuchtung aufweist, der Kühlkörper mit der Ausbuchtung einstückig oder mehrstückig ausgebildet.

Bei dieser vorteilhaften Ausgestaltungsform kann mit Wahl der mehrstückigen Ausbildung beispielsweise eine Nachrüstung der Ausbuchtung bei der planen Bodenplatte oder, sofern der Kühlkörper die Ausbuchtung aufweist, bei dem planen Kühlkörper erzielt werden.

Dies ist insbesondere dann vorteilhaft, wenn der Kühlkörper und das Leistungshalbleitermodul mit der Bodenplatte noch nicht miteinander mechanisch verbunden sind.

Die Ausbuchtung ist mittels verschiedener mechanischer Verbindungsverfahren - beispielsweise Sintern, Löten oder Kleben - mit der planen Bodenplatte oder dem planen Kühlkörper verbindbar. Dabei werden Verbindungsverfahren bevorzugt, welche ebenfalls einen für den Betrieb niedrigen thermischen Widerstand erzeugen.

Bei einer weiteren vorteilhaften Ausgestaltungsform der erfindungsgemäßen Kühlvorrichtung ist bei der mehrstückigen Ausbildung das Material der Bodenplatte unterschiedlich zu dem Material der Ausbuchtung oder, sofern der Kühlkörper die Ausbuchtung aufweist, ist das Material des Kühlkörpers unterschiedlich zu dem Material der Ausbuchtung.

Ist nach diesem Ausführungsbeispiel die mehrstückige Ausbildung von Ausbuchtung und planer Bodenplatte oder von Ausbuchtung und planem Kühlkörper vorgesehen, kann mit Wahl eines thermisch besonders gut leitenden Materials der thermische Widerstand der zu bildenden mechanisch-thermischen Verbindung von Ausbuchtung und planer Bodenplatte oder von Ausbuchtung und planem Kühlkörper in vorteilhafter Weise weiter verringert werden.

Bei einer weiteren vorteilhaften Ausgestaltungsform der erfindungsgemäßen Kühlvorrichtung ist die Ausbuchtung durch mehrere Teilausbuchtungen gebildet, ist die Einbuchtung durch mehrere Teileinbuchtungen gebildet und ist jede der Teilausbuchtungen in jeweils einer der Teileinbuchtungen zumindest teilweise versenkbar oder vollständig versenkbar.

Durch die Ausbildung der Ausbuchtung und der Einbuchtung mittels entsprechender Teilausbuchtungen und entsprechender Teileinbuchtungen wird die jeweilige Oberfläche der gemeinsamen mechanisch-thermischen Verbindung von Bodenplatte und Kühlkörper derart vergrößert, das der thermischen Widerstand dieser Verbindung in vorteilhafter Weise im Betrieb weiter reduziert wird.

Bei einer weiteren vorteilhaften Ausgestaltungsform der erfindungsgemäßen Kühlvorrichtung weist die Einbuchtung und die in die Einbuchtung versenkbare Ausbuchtung jeweils ein gleiches geometrisches Profilbild auf, insbesondere ein Viereck, ein Dreieck oder einen Halbkreis.

Damit die Ausbuchtung in die Einbuchtung mechanisch zuverlässig und beispielsweise auch vollständig versenkbar ist und die Bodenplatte und der Kühlkörper zur Erzielung des niedrigen thermischen Widerstands möglichst formschlüssig eng miteinander thermisch/mechanisch verbunden sind, wird das geometrische Profilbild von Ausbuchtung und Einbuchtung bei dieser vorteilhaften Ausgestaltungsform gleich gewählt.

Bei einer weiteren vorteilhaften Ausgestaltungsform der erfindungsgemäßen Kühlvorrichtung ist die Ausbuchtung mechanisch lösbar oder mechanisch unlösbar durch ein Verbindungsmittel mit der Einbuchtung verbindbar.

Die lösbare mechanische Verbindung hat den Vorteil einer vergleichsweise aufwandsarmen Herstellung bzw. Lösung der mechanischen und damit auch thermischen Verbindung der Ausbuchtung mit der Einbuchtung, also der Bodenplatte des Leistungshalbleitermoduls mit dem Kühlkörper. Als Verbindungsmittel für lösbare Verbindungen können beispielsweise Schraubverbindungen, Steckverbindungen oder Klemmverbindungen verwendet werden.

Als unlösbare mechanische Verbindung werden mechanische Verbindungen bezeichnet, welche erst durch mechanische Zerstörung wieder gelöst werden können. Die unlösbare mechanische und damit auch thermische Verbindung der Ausbuchtung mit der Einbuchtung hat hier den Vorteil, dass im Verlaufe der Lebensdauer dieser Verbindung in der Regel die Stabilität und somit deren Funktionalität erhalten bleibt und daher kaum Wartungsarbeiten über diese Lebensdauer hinweg notwendig werden. Als Verbindungsmittel für unlösbare Verbindung können beispielsweise Sinterverbindungen, Lötverbindungen oder Klebverbindungen verwendet werden.

Bei einer weiteren vorteilhaften Ausgestaltungsform der erfindungsgemäßen Kühlvorrichtung weist die mechanische Verbindung der Ausbuchtung mit der Einbuchtung einen Zwischenraum auf, welcher mittels eines Wärmeleitmaterials verfüllbar ist.

Da die Ausbuchtung und die Einbuchtung der Bodenplatte bzw. des Kühlkörpers aufgrund von Bearbeitungsverfahren unterschiedlicher Technologie und Qualität am zu bearbeitenden Material oftmals Unebenheiten hinterlassen oder das Material diese Unebenheiten aufgrund seiner Materialstruktur inhärent aufweist, entstehen bei der thermisch/mechanischen Verbindung der Ausbuchtung mit der Einbuchtung häufig Zwischenräume. Daher kann auch bei einer vollständigen Versenkung der Ausbuchtung in die Einbuchtung nicht zwangsläufig an jeder Stelle dieser thermisch/mechanischen Verbindung von der formschlüssigen Verbindung ausgegangen werden.

Um dennoch den thermischen Widerstand dieser thermisch/mechanischen Verbindung in vorteilhafter Weise möglichst gering zu halten, sind Wärmeleitmaterialien vorgesehen, welche jedoch nicht nur Wärme gut leiten, sondern oftmals auch vorgesehen sind, die entstandenen Zwischenräume möglichst vollständig auszufüllen. Das gibt der thermisch/mechanischen Verbindung zusätzliche mechanische Stabilität, insbesondere dann, wenn die Ausbuchtung in die Einbuchtung nicht vollständig versenkt ist.

Bei einer weiteren vorteilhaften Ausgestaltungsform der erfindungsgemäßen Kühlvorrichtung ist mittels deckungsgleicher Anordnung der Ausbuchtung gegenüber der Einbuchtung eine Positionierung für die mechanische Verbindung der Bodenplatte mit dem Kühlkörper ohne weitere Positionierungshilfsmittel vorgesehen.

Bei dieser Ausgestaltungsform wird davon ausgegangen, dass die Ausbuchtung einer zugehörigen Einbuchtung zuordenbar ist, die Ausbuchtung gegenüber der Einbuchtung deckungsgleich angeordnet ist, die Ausbuchtung und die Einbuchtung jeweils formgleich sind und die Ausbuchtung zumindest teilweise in die Einbuchtung versenkbar ist. Gleiches gilt auch für eine Verbindungsbeziehung zwischen Teilausbuchtung und Teileinbuchtung. Aufgrund der genannten Bedingungen sind Ausbuchtung und Einbuchtung für die Herstellung der mechanisch-thermischen Verbindung von der Bodenplatte mit dem Kühlkörper in vorteilhafter und geeigneter Weise positioniert, weitere Positionierungshilfsmittel sind nicht vorgesehen.

Für die Lösung der Aufgabe wird ferner ein Stromrichter mit einer erfindungsgemäßen Kühlvorrichtung vorgeschlagen, wobei die Kühlvorrichtung einen Kühlkörper und ein Leistungshalbleitermodul umfasst, wobei das Leistungshalbleitermodul eine Bodenplatte und mindestens einen Leistungshalbleiter-Chip aufweist, wobei die Bodenplatte an ihrer ersten Seite mechanisch mit dem mindestens einen Leistungshalbleiter-Chip verbunden ist, wobei der Kühlkörper mit der Bodenplatte mechanisch verbindbar ist und im Betrieb eine Wärmesenke für die von dem mindestens einen Leistungshalbleiter-Chip als Wärmequelle über die Bodenplatte abgegebene Verlustwärme bildet, wobei an einer von der ersten Seite der Bodenplatte abgewandten und dem Kühlkörper zugewandten zweiten Seite der Bodenplatte eine Ausbuchtung vorgesehen ist, wobei an dem Kühlkörper eine als Negativabbild der Ausbuchtung der Bodenplatte ausgebildete Einbuchtung vorgesehen ist und wobei die Ausbuchtung der Bodenplatte in die Einbuchtung des Kühlkörpers zumindest teilweise versenkbar ist.

Stromrichter im industriellen Umfeld unterliegen immer stringenteren Anforderungen an thermische, elektrische und geometrische (möglichst platzsparende) Eigenschaften ihrer Baugruppen. Der Einsatz der erfindungsgemäßen Kühlvorrichtung verbessert in vorteilhafter Weise das thermische Verhalten des Leistungshalbleitermoduls im Stromrichter, wobei gleichzeitig auch dessen Freiheitsgrade bzgl. der Einbaumöglichkeiten des Leistungshalbleitermoduls (Einbauort, Einbaulage und Einbaugröße) bei der Bildung von beispielsweise elektrischen Brückenschaltungen verbessert werden. Dies ist hier ohne Einbußen bzw. unter Verbesserung der elektrischen Eigenschaften (zum Beispiel der Leistungsdaten) des Leistungshalbleitermoduls möglich.

Bei einer weiteren vorteilhaften Ausgestaltungsform des Stromrichters sieht die Kühlvorrichtung an der von der ersten Seite der Bodenplatte abgewandten und dem Kühlkörper zugewandten zweiten Seite der Bodenplatte eine Einbuchtung vor, sieht die Kühlvorrichtung an dem Kühlkörper eine als Negativabbild der Einbuchtung der Bodenplatte ausgebildete Ausbuchtung des Kühlkörpers vor und ist die Ausbuchtung des Kühlkörpers in die Einbuchtung der Bodenplatte zumindest teilweise versenkbar ist.

Bei einer weiteren vorteilhaften Ausgestaltungsform des Stromrichters ist der Stromrichter in einem elektrischen Antriebssystem vorgesehen, eine elektrische Maschine an einem elektrischen Netz zu betreiben oder ist der Stromrichter vorgesehen, bei der Energieerzeugung und Energieverteilung elektrische Energie am elektrischen Netz umzuformen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Querschnitts-Darstellung eines Leistungshalbleitermoduls mit einem Kühlkörper nach dem Stand der Technik,
- FIG 2: eine erste schematische Querschnitts-Darstellung einer erfindungsgemäßen Kühlvorrichtung zur Entwärmung eines Leistungshalbleitermoduls,
- FIG 3: eine zweite schematische Querschnitts-Darstellung der erfindungsgemäßen Kühlvorrichtung zur Entwärmung des Leistungshalbleitermoduls nach FIG 2,
- FIG 4: eine dritte schematische Querschnitts-Darstellung der erfindungsgemäßen Kühlvorrichtung zur Entwärmung des Leistungshalbleitermoduls nach FIG 2,
- FIG 5: ein Diagramm zur Darstellung eines ersten und eines zweiten thermischen Widerstandsverlaufs der erfindungsgemäßen Kühlvorrichtung zur Entwärmung des Leistungshalbleitermoduls aus FIG 2 und FIG 3,
- FIG 6: ein Diagramm zur Darstellung eines ersten und eines zweiten Temperaturhubs der erfindungsgemäßen Kühlvorrichtung zur Entwärmung des Leistungshalbleitermoduls aus FIG 2 und FIG 3 und
- FIG 7: eine schematische Darstellung eines erfindungsgemäßen Stromrichters mit der erfindungsgemäßen Kühlvorrichtung zur Entwärmung des Leistungshalbleitermoduls aus FIG 2, FIG 3 oder FIG 4, betrieben in einem elektrischen Antriebssystem an einem elektrischen Netz.

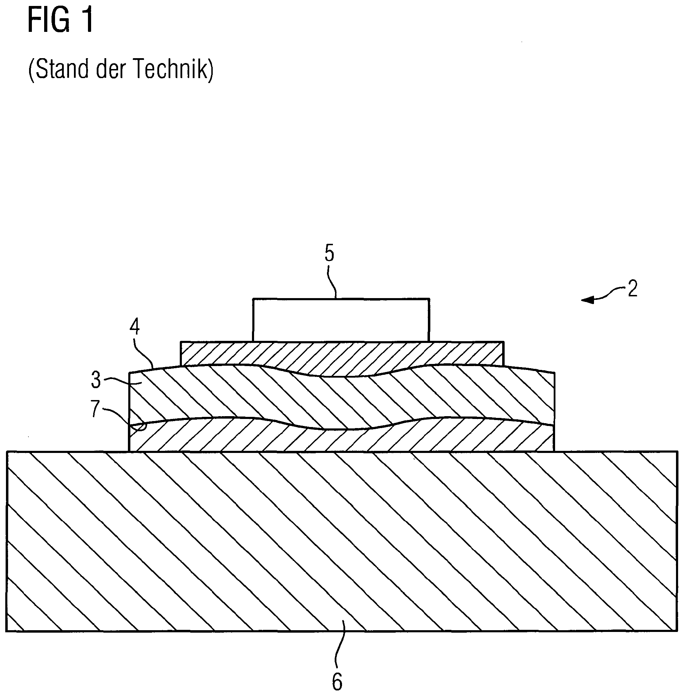

In FIG 1 wird mittels einer schematischen Querschnitts-Darstellung eine mechanische Verbindung eines Leistungshalbleitermoduls (2) mit einem Kühlkörper (6) nach dem Stand der Technik gezeigt.

Das Leistungshalbleitermodul (2) weist einen Leistungshalbleiter-Chip (5) und eine Bodenplatte (3) auf, wobei die Bodenplatte (3) an ihrer ersten Seite (4) mechanisch mit dem Leistungshalbleiter-Chip (5) verbunden ist. Ferner ist die Bodenplatte (3) an ihrer zweiten Seite (7) mit dem Kühlkörper (6) mechanisch verbunden. Im Betrieb wird insbesondere bei Schaltvorgängen des Leistungshalbleiter-Chips (5) eine Verlustwärme erzeugt, welche über die Bodenplatte (3) an den Kühlkörper (6) abführbar ist.

Der Aufbau des Leistungshalbleitermoduls (2) wird in FIG 1 vereinfacht dargestellt. Zu erkennen ist, dass sich bei der mechanischen Verbindung der zweiten Seite (7) der Bodenplatte (3) mit dem Kühlkörper (6) deren gemeinsam verbundene Oberflächen zwar in eher geringem Maße überlappen (kann hier in der Querschnitt-Darstellung nur angedeutet werden), jedoch die Bodenplatte (3) aufgrund von beispielsweise Fertigungstoleranzen oder spezifischen Materialeigenschaften eine Welligkeit aufweist.

Diese Eigenschaften für die mechanische Verbindung nach FIG 1 wirken sich auf die Erzeugung einer damit einhergehenden thermischen Verbindung - und somit auf einen möglichst niedrigen thermischen Widerstand der mechanischen Verbindung - eher negativ aus. Hier kann ggf. noch eine Verbesserung erreicht werden, wenn diese mechanische Verbindung mit einem mechanischen Druck beaufschlagt wird.

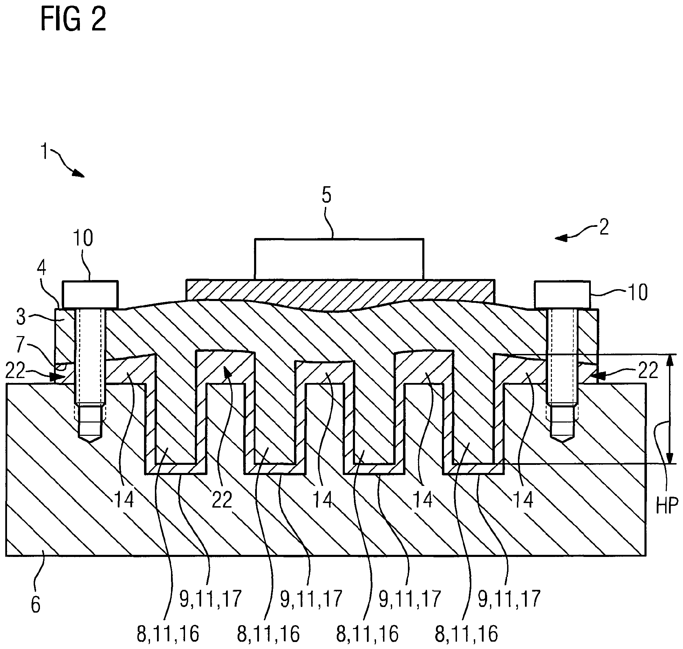

Die FIG 2 zeigt mittels einer ersten schematischen Querschnitts-Darstellung eine erfindungsgemäße Kühlvorrichtung (1) zur Entwärmung eines Leistungshalbleitermoduls (2).

Der Aufbau des Leistungshalbleitermoduls (2) wird in FIG 2 vereinfacht dargestellt.

Ein Leistungshalbleiter-Chip (5) des Leistungshalbleitermoduls (2) der Kühlvorrichtung (1) erzeugt als Wärmequelle im Betrieb Verlustwärme, welche über eine Bodenplatte (3) des Leistungshalbleitermoduls (2) an einen Kühlkörper (6) der Kühlvorrichtung (1) abgebbar ist.

Die Bodenplatte (3) ist dabei an ihrer ersten Seite (4) mechanisch mit dem Leistungshalbleiter-Chip (5) verbunden und an ihrer zweiten Seite (7) mechanisch mit dem Kühlkörper (6) verbunden. Die zweite Seite (7) der Bodenplatte (3), welche dem Kühlkörper (6) zugewandt ist, weist vier Teilausbuchtungen (16) auf, welche zusammen eine Ausbuchtung (8) der Boden-platte (3) bilden.

Der Kühlkörper (6) weist als Negativabbild der Teilausbuchtungen (16) der Bodenplatte (3) vier Teileinbuchtungen (17) auf, welche zusammen eine Einbuchtung (9) des Kühlkörpers (6) bilden.

Alle vier Teilausbuchtungen (16) der Bodenplatte (3) weisen eine Profiltiefe (HP) auf und sind zumindest teilweise in den jeweiligen als Negativabbild der Teilausbuchtungen (16) vorhandenen vier Teileinbuchtungen (17) des Kühlkörpers (6) versenkt.

Ein zwischen der Bodenplatte (3) und dem Kühlkörper (6) - also auch zwischen den vier Teilausbuchtungen (16) der Bodenplatte (3) und den vier Teileinbuchtungen (17) des Kühlkörpers (6)- gebildeter Zwischenraum (22) wird mit einem Wärmeleitmaterial (14) verfüllt.

Die mechanisch-thermische Verbindung zwischen Bodenplatte (3) und Kühlkörper (6) wird im Beispiel der FIG 2 durch ein Verbindungsmittel (10) erzeugt. Das Verbindungmittel (10) ist hier als Schraube ausgeführt, mittels der ein mechanischer Druck auf die mechanisch/thermische Verbindung ausübbar ist.

Sowohl die vier Teilausbuchtungen (16) der Bodenplatte (3) wie auch die vier Teileinbuchtungen (17) des Kühlkörpers (6) weisen in FIG 2 ein gleiches geometrisches Profilbild, hier ein Viereck (11), auf.

In FIG 2 wird im Gegensatz zum Stand der Technik aus FIG 1 gezeigt, dass sich mittels der Kühlvorrichtung (1) bei der mechanischen Verbindung der zweiten Seite (7) der Bodenplatte (3) mit dem Kühlkörper (6) deren gemeinsam verbundene Oberflächen in weit größerem Maße überlappen lässt (kann hier in der Querschnitt-Darstellung nur angedeutet werden).

Diese Eigenschaften für die mechanische Verbindung nach FIG 2 wirken sich auf die Erzeugung der damit einhergehenden thermischen Verbindung - und somit auf einen möglichst niedrigen thermischen Widerstand der mechanischen Verbindung - im Vergleich zum Stand der Technik in FIG 1 verbessernd aus.

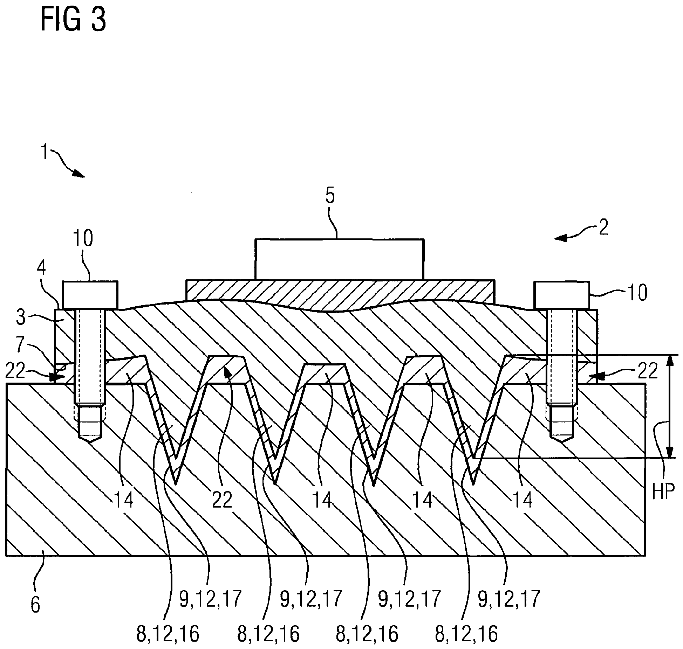

Eine zweite schematische Querschnitts-Darstellung der erfindungsgemäßen Kühlvorrichtung (1) zur Entwärmung des Leistungshalbleitermoduls (2) nach FIG 2 wird in FIG 3 aufgezeigt.

Die FIG 3 entspricht der FIG 2 mit dem Unterschied, dass sowohl die vier Teilausbuchtungen (16) der Bodenplatte (3) wie auch die vier Teileinbuchtungen (17) des Kühlkörpers (6) hier als gleiches geometrisches Profilbild ein Dreieck (12) aufweisen.

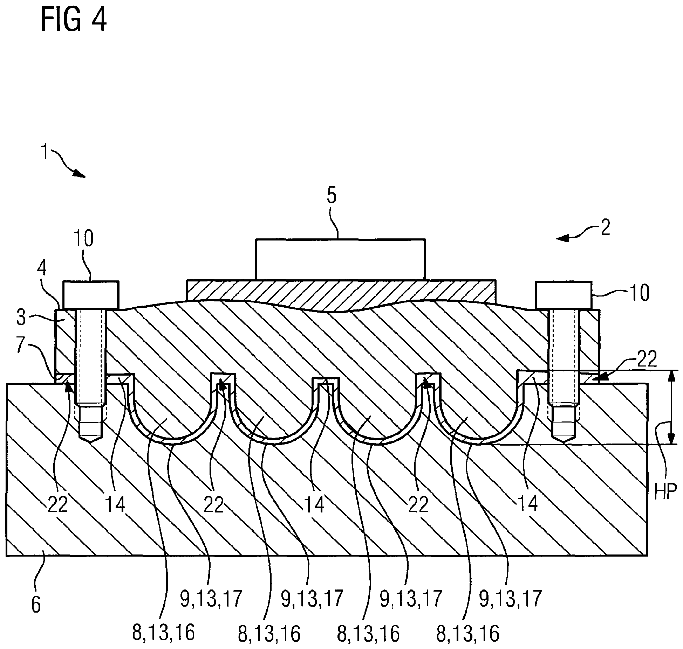

Eine dritte schematische Querschnitts-Darstellung der erfindungsgemäßen Kühlvorrichtung (1) zur Entwärmung des Leistungshalbleitermoduls (2) nach FIG 2 wird in FIG 4 aufgezeigt.

Die FIG 4 entspricht der FIG 2 mit dem Unterschied, dass sowohl die vier Teilausbuchtungen (16) der Bodenplatte (3) wie auch die vier Teileinbuchtungen (17) des Kühlkörpers (6) hier als gleiches geometrisches Profilbild einen Halbkreis (13) aufweisen.

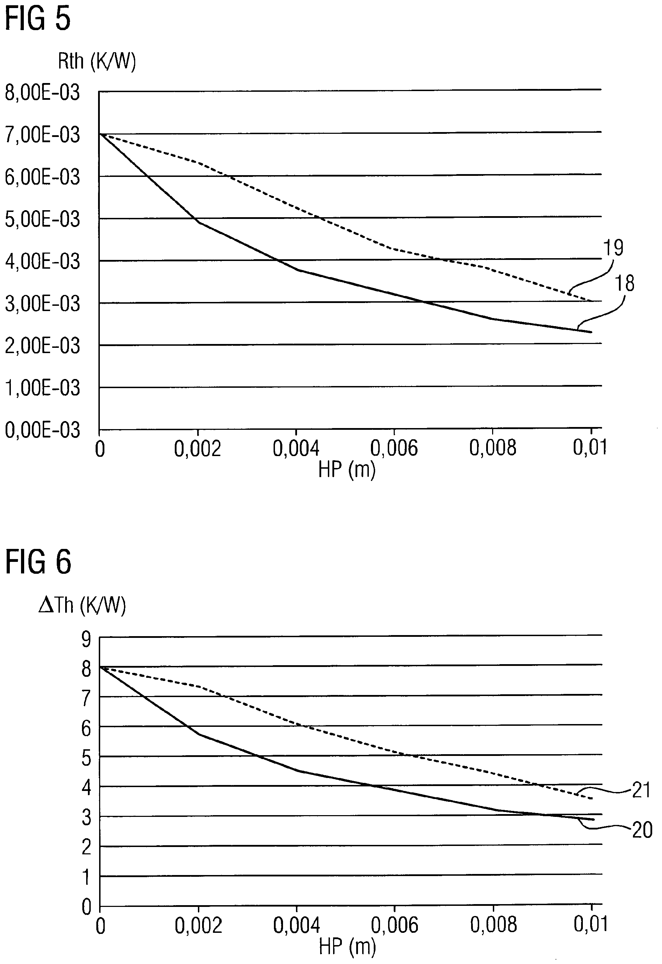

In FIG 5 wird ein Diagramm zur Darstellung eines ersten und eines zweiten thermischen Widerstandsverlaufs (18,19) der erfindungsgemäßen Kühlvorrichtung (1) zur Entwärmung des Leistungshalbleitermoduls (2) aus FIG 2 und FIG 3 gezeigt.

Der erste thermische Widerstandsverlaufs (18) kennzeichnet hier als Kurve - über mögliche Profilhöhen (HP) der jeweiligen Teilausbuchtungen (16) der Bodenplatte (3) nach FIG 2 hinweg (von im Diagramm der FIG 5 von 0m bis 0,01m) - den thermischen Widerstand (Rth) der in FIG 2 gezeigten mechanisch-thermischen Verbindung der Bodenplatte (3) mit der Kühlkörper (6). Als gleiches geometrisches Profilbild der Teilausbuchtungen (16) und der Teileinbuchtungen (17) kommt hier das Viereck (11) zum Einsatz.

Der zweite thermische Widerstandsverlaufs (19) kennzeichnet hier als weitere Kurve - über mögliche Profilhöhen (HP) der jeweiligen Teilausbuchtungen (16) der Bodenplatte (3) nach FIG 3 hinweg (im Diagramm der FIG 5 von 0m bis 0,01m) - den thermischen Widerstand (Rth) der in FIG 3 gezeigten mechanisch-thermischen Verbindung der Bodenplatte (3) mit dem Kühlkörper (6). Als gleiches geometrisches Profilbild der Teilausbuchtungen (16) und der Teileinbuchtungen (17) kommt hier das Dreieck (12) zum Einsatz.

Der Vergleich der beiden thermischen Widerstandsverläufe (18,19) zeigt, dass bei Einsatz des Vierecks (11) als gleiches Profilbild der Teilausbuchtungen (16) und der Teileinbuchtungen (17) (siehe FIG 2) eine Verbesserung des thermischen Widerstands (Rth) gegenüber dem Einsatz des Dreiecks (11) als gleiches Profilbild der Teilausbuchtungen (16) und der Teileinbuchtungen (17) (siehe FIG 3) nachweisbar ist.

Das Diagramm der FIG 5 wurde unter der Annahme einer Verlustleistung von ca. 1100W im Betrieb der jeweiligen Leistungshalbleiter-Chips (5) nach FIG 2 und FIG 3 sowie unter der Annahme eines konstanten mechanischen Drucks auf die mechanisch-thermische Verbindung von Bodenplatte (3) und Kühlkörper (6) nach FIG 2 und FIG 3 erstellt.

In FIG 6 wird ein Diagramm zur Darstellung eines ersten und eines zweiten Temperaturhubverlaufs (20,21) der erfindungsgemäßen Kühlvorrichtung (1) zur Entwärmung des Leistungshalbleitermoduls (2) aus FIG 2 und FIG 3 gezeigt.

Der erste Temperaturhubverlauf (20) kennzeichnet hier als Kurve - über mögliche Profilhöhen (HP) der jeweiligen Teilausbuchtungen (16) der Bodenplatte (3) nach FIG 2 hinweg (im Diagramm der FIG 6 von 0m bis 0,01m) - den Temperaturhub (ΔTh) der in FIG 2 gezeigten mechanisch-thermischen Verbindung der Bodenplatte (3) mit dem Kühlkörper (6). Als gleiches geometrisches Profilbild der Teilausbuchtungen (16) und der Teileinbuchtungen (17) kommt hier das Viereck (11) zum Einsatz.

Der zweite Temperaturhubverlauf (21) kennzeichnet hier als weitere Kurve - über mögliche Profilhöhen (HP) der jeweiligen Teilausbuchtungen (16) der Bodenplatte (3) nach FIG 3 hinweg (im Diagramm der FIG 6 von 0m bis 0,01m) - den Temperaturhub (ΔTh) der in FIG 3 gezeigten mechanisch-thermischen Verbindung der Bodenplatte (3) mit dem Kühlkörper (6). Als gleiches geometrisches Profilbild der Teilausbuchtungen (16) und der Teileinbuchtungen (17) kommt hier das Dreieck (12) zum Einsatz.

Der Vergleich der beiden Temperaturhubverläufe (20,21) zeigt, dass bei Einsatz des Vierecks (11) als gleiches Profilbild der Teilausbuchtungen (16) und der Teileinbuchtungen (17) (siehe FIG 2) eine Verbesserung des Temperaturhubs (ΔTh) gegenüber dem Einsatz des Dreiecks (11) als gleiches Profilbild der Teilausbuchtungen (16) und der Teileinbuchtungen (17) (siehe FIG 3) nachweisbar ist.

Das Diagramm der FIG 6 wurde ebenfalls unter der Annahme einer Verlustleistung von ca. 1100W im Betrieb der jeweiligen Leistungshalbleiter-Chips (5) nach FIG 2 und FIG 3 sowie unter der Annahme eines konstanten mechanischen Drucks auf die mechanisch-thermische Verbindung von Bodenplatte (3) und Kühlkörper (6) nach FIG 2 und FIG 3 erstellt.

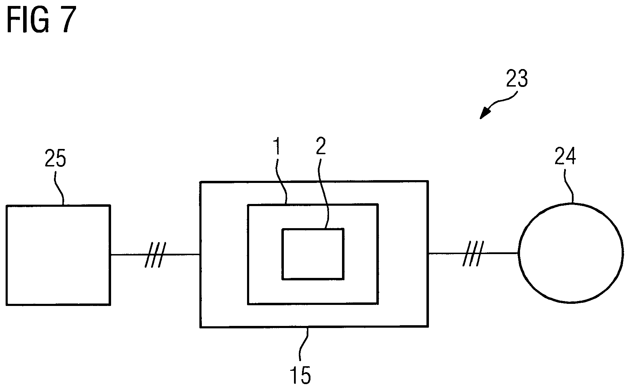

In der FIG 7 wird in einer schematischen Darstellung ein erfindungsgemäßer Stromrichter (15) mit der erfindungsgemäßen Kühlvorrichtung (1) zur Entwärmung des Leistungshalbleitermoduls (2) aus FIG 2, FIG 3 oder FIG 4 gezeigt, welcher in einem elektrischen Antriebssystem (23) an einem elektrischen Netz (25) betrieben wird. Der Stromrichter (15) treibt eine elektrische Maschine (24) in dem elektrischen Antriebssystem (23). Sowohl das mit dem Stromrichter (15) elektrische verbundene elektrische Netz (25) wie die im elektrischen Antriebssystem (23) mit dem Stromrichter (15) elektrisch verbundene elektrische Maschine (24) weisen hier beispielhaft ein dreiphasiges Drehstromsystem auf.

## Patentansprüche

1. Kühlvorrichtung (1) zur Entwärmung eines Leistungshalbleitermoduls (2), umfassend das Leistungshalbleitermodul (2) und einen Kühlkörper (6), wobei
- das Leistungshalbleitermodul (2) eine Bodenplatte (3) und mindestens einen Leistungshalbleiter-Chip (5) aufweist,
- die Bodenplatte (3) an ihrer ersten Seite (4) mechanisch mit dem mindestens einen Leistungshalbleiter-Chip (5) verbunden ist,
- die Bodenplatte (3) mit dem Kühlkörper (6) mechanisch verbindbar ist und der Kühlkörper (6) im Betrieb eine Wärmesenke für die von dem mindestens einen Leistungshalbleiter-Chip (5) als Wärmequelle über die Bodenplatte (3) abgegebene Verlustwärme bildet,
- an einer von der ersten Seite (4) der Bodenplatte (3) abgewandten und dem Kühlkörper (6) zugewandten zweiten Seite (7) der Bodenplatte (3) eine Ausbuchtung (8) vorgesehen ist,
- an dem Kühlkörper (6) eine als Negativabbild der Ausbuchtung (8) der Bodenplatte (3) ausgebildete Einbuchtung (9) vorgesehen ist und
- die Ausbuchtung (8) der Bodenplatte (3) in die Einbuchtung (9) des Kühlkörpers (6) zumindest teilweise versenkbar ist.

2. Kühlvorrichtung nach Anspruch 1, wobei an der von der ersten Seite der Bodenplatte abgewandten und dem Kühlkörper zugewandten zweiten Seite der Bodenplatte eine Einbuchtung vorgesehen ist,
- an dem Kühlkörper eine als Negativabbild der Einbuchtung der Bodenplatte ausgebildete Ausbuchtung vorgesehen ist und
- die Ausbuchtung des Kühlkörpers in die Einbuchtung der Bodenplatte zumindest teilweise versenkbar ist.

3. Kühlvorrichtung (1) nach einem der Ansprüche 1 oder 2, wobei die Ausbuchtung (8) in die Einbuchtung (9) vollständig versenkbar ist.

4. Kühlvorrichtung (1) nach einem der vorhergehenden Ansprüche, wobei die in die Einbuchtung (9) versenkte Ausbuchtung (8) eine Profilhöhe (HP) aufweist, welche mindestens 3mm in die Einbuchtung (9) ragt.

5. Kühlvorrichtung (1) nach einem der vorhergehenden Ansprüche, wobei die Bodenplatte (3) mit der Ausbuchtung (8) oder, sofern der Kühlkörper die Ausbuchtung aufweist, der Kühlkörper mit der Ausbuchtung einstückig oder mehrstückig ausgebildet ist.

6. Kühlvorrichtung (1) nach Anspruch 5, wobei bei der mehrstückigen Ausbildung das Material der Bodenplatte (3) unterschiedlich zu dem Material der Ausbuchtung (8) ist oder, sofern der Kühlkörper die Ausbuchtung aufweist, das Material des Kühlkörpers unterschiedlich zu dem Material der Ausbuchtung ist.

7. Kühlvorrichtung (1) nach einem der vorhergehenden Ansprüche, wobei
- die Ausbuchtung (8) durch mehrere Teilausbuchtungen (16) gebildet ist,
- die Einbuchtung (9) durch mehrere Teileinbuchtungen (17) gebildet ist und
- jede der Teilausbuchtungen (16) in einer der Teileinbuchtungen (17) zumindest teilweise versenkbar oder vollständig versenkbar ist.

8. Kühlvorrichtung (1) nach einem der vorhergehenden Ansprüche, wobei die Einbuchtung (9) und die in die Einbuchtung (9) versenkbare Ausbuchtung (8) jeweils ein gleiches geometrisches Profilbild aufweisen, insbesondere ein Viereck (11), ein Dreieck (12) oder einen Halbkreis (13).

9. Kühlvorrichtung (1) nach einem der vorhergehenden Ansprüche, wobei die Ausbuchtung (8) mechanisch lösbar oder mechanisch unlösbar durch ein Verbindungsmittel (10) mit der Einbuchtung (9) verbindbar ist.

10. Kühlvorrichtung (1) nach einem der vorhergehenden Ansprüche, wobei die mechanische Verbindung der Ausbuchtung (8) mit der Einbuchtung (9) einen Zwischenraum (22) aufweist, welcher mittels eines Wärmeleitmaterials (14) verfüllbar ist.

11. Kühlvorrichtung (1) nach einem der vorhergehenden Ansprüche, wobei mittels deckungsgleicher Anordnung der Ausbuchtung (8) gegenüber der Einbuchtung (9) eine Positionierung für die mechanische Verbindung der Bodenplatte (3) mit dem Kühlkörper (6) ohne weitere Positionierungshilfsmittel vorgesehen ist.

12. Stromrichter (15) mit einer Kühlvorrichtung (1) nach einem der Ansprüche 1 bis 11, wobei
- die Kühlvorrichtung (1) einen Kühlkörper (6) und ein Leistungshalbleitermodul (2) umfasst,
- das Leistungshalbleitermodul (2) eine Bodenplatte (3) und mindestens einen Leistungshalbleiter-Chip (5) aufweist,
- die Bodenplatte (3) an ihrer ersten Seite (4) mechanisch mit dem mindestens einen Leistungshalbleiter-Chip (5) verbunden ist,
- der Kühlkörper (6) mit der Bodenplatte (3) mechanisch verbindbar ist und im Betrieb eine Wärmesenke für die von dem mindestens einen Leistungshalbleiter-Chip (5) als Wärmequelle über die Bodenplatte (3) abgegebene Verlustwärme bildet,
- an einer von der ersten Seite (4) der Bodenplatte (3) abgewandten und dem Kühlkörper (6) zugewandten zweiten Seite (7) der Bodenplatte (3) eine Ausbuchtung (8) vorgesehen ist,
- an dem Kühlkörper (6) eine als Negativabbild der Ausbuchtung (8) der Bodenplatte (3) ausgebildete Einbuchtung (9) vorgesehen ist und
- die Ausbuchtung (8) der Bodenplatte (3) in die Einbuchtung (9) des Kühlkörpers (6) zumindest teilweise versenkbar ist.

13. Stromrichter nach Anspruch 12, wobei
- an der von der ersten Seite der Bodenplatte abgewandten und dem Kühlkörper zugewandten zweiten Seite der Bodenplatte eine Einbuchtung vorgesehen ist,
- an dem Kühlkörper eine als Negativabbild der Einbuchtung der Bodenplatte ausgebildete Ausbuchtung der Kühlkörpers vorgesehen ist und
- die Ausbuchtung des Kühlkörpers in die Einbuchtung der Bodenplatte zumindest teilweise versenkbar ist.

14. Stromrichter (15) nach einem der Ansprüche 12 oder 13, wobei der Stromrichter (15) vorgesehen ist, eine elektrische Maschine (24) in einem elektrischen Antriebssystem (23) an einem elektrischen Netz (25) zu betreiben oder wobei der Stromrichter vorgesehen ist, bei der Energieerzeugung und/oder Energieverteilung elektrische Energie am elektrischen Netz umzuformen.
